# EUROPEAN PATENT APPLICATION

(11) **EP 2 947 757 A1**
(43) Date of publication of application: **25.11.2015**
(21) Application number: 14169272.3
(22) Date of filing: 21.05.2014
(51) Int. Cl.: H02K 11/02, H01G 4/38, H01G 4/40

(54) **Electronic component with stacked elements**

(71) Applicant: Keko-Varicon d.o.o., 8360 Zuzemberk (SI)
(72) Inventor: PRAZNIK, Robert, 8360 Zuzemberk (SI); SENICA, Franci, 8361 Dvor (HR)
(74) Representative: Lucke, Andreas

(57) **Abstract**

The present invention relates to filtering voltage disturbances generated by electronic circuits, electrical motors or machines. By switching off/on the electrical current of an inductive load, the switching inherently results in voltage surges or peaks being induced. Consequently, broadband electromagnetic disturbances are generated which degrade the performance of devices picking up the disturbances via paths of radiated emission or electrically conductive connections. The present invention suggests an electronic filter component including a plurality of stacked electronic elements having conductive areas on their outer surface. The conductive areas of adjacently stacked electronic elements are electronically connected and at least one of the electronic elements comprises at least two capacitors. Consequently, a compact electronic filter component with short connection paths is provided. By shortening the connection paths in the circuit, the electronic component is less suited to emit electromagnetic interferences, which results in improved filter performance. The present invention further relates to an electrical motor, electrical machine and brush-commutator including the electronic component, and a method of manufacturing the electronic component.

## Description

### FIELD OF THE INVENTION

The present invention is in the field of electronic filtering of electromagnetic interferences (EMI) generated by electronic circuits, electrical motors or machines. The present invention comprises an electronic component for filtering voltage disturbances, as well as an electrical motor, electrical machine or brush-commutator comprising the electronic component. The present invention further comprises a method of manufacturing the electronic component.

### BACKGROUND OF THE INVENTION

The operation of many types of electrical systems and circuits results in the generation of voltage surges and spikes. For example, many power circuits and DC motor brush-commutators act as switches to switch off/on electrical currents. By switching off/on the electrical current of an inductive load, the switching inherently results in voltage surges or peaks being induced by the inductive load. As a result, broadband electromagnetic interferences (EMI) are generated in the frequency domain, which add to noise and disturbance levels and degrade the performance of electronic devices susceptible to picking up such electromagnetic interferences via paths of radiated emission or electrically conductive connections. For example, the operability and performance of wireless data systems, communication systems, data management systems, computing systems, monitoring systems, control systems, bus systems and sensor systems can be impaired by effects of electromagnetic interferences. This holds in particular for environments where electrically motorized components are adapted to work in the vicinity of sensitive low-voltage circuits. This is for example the case in a car environment, where an electric DC-brush wiper motor is being powered close to a car multimedia system.

The need to effectively suppress broadband electromagnetic interferences (EMI) has been a major driving factor in the development of electromagnetic interference filters.

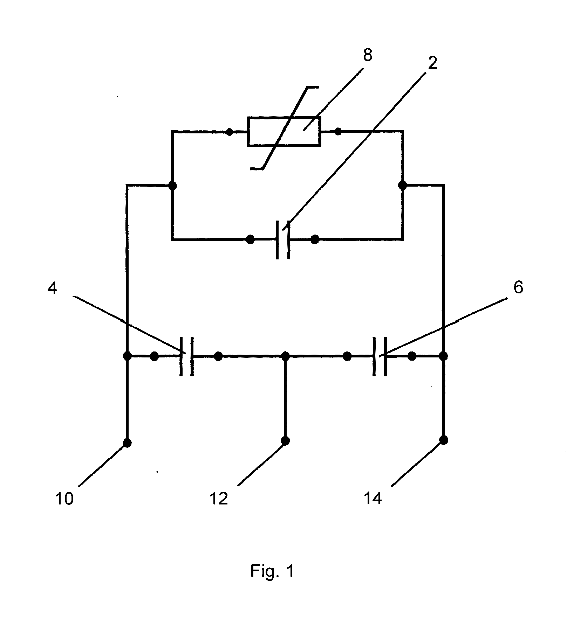

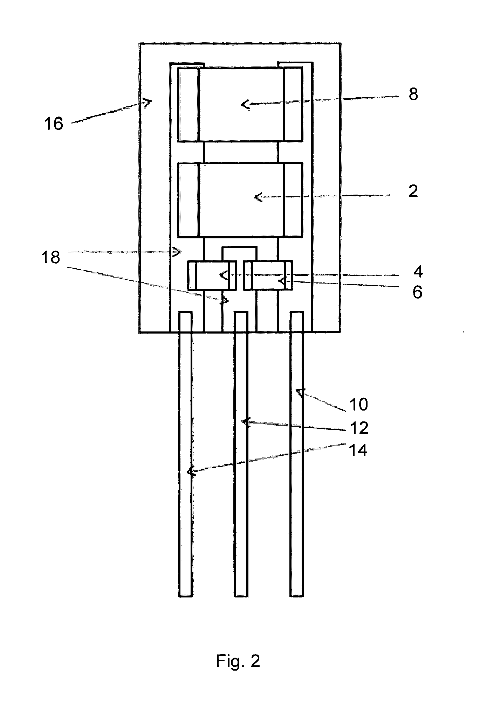

SI23196A discloses an electronic filter for limiting voltage disturbances of DC brush drives. The filter comprises three capacitors (2, 4, 6) and one varistor (8) for suppressing voltage surges or spikes generated by on/off switching in a DC brush motor. The filter also protects against arcing in the brush drive's commutator and the varistor (8) provides additional overvoltage protection for the drive. In this respect, the four electronic components are connected as illustrated in Fig. 1 by having the varistor (8) connected in parallel to one of the capacitors (2) and also in parallel to a series connection of the two remaining capacitors (4, 6). Three terminals (10, 12, 14) are connected to the filter and arranged to simplify and reduce the cost of filter installation. The overall size of the filter is reduced by having the electronic filter manufactured as shown in Fig. 2. Here, the individual components (2, 4, 6, 8) are soldered on a printed circuit board (16) and electrically connected to form the filter circuit of Fig. 1 with external connectors (10, 12, 14). All connections are realized by the use of copper connection paths (18). This arrangement of components saves space and enables a compact installation of the filter, which is particularly useful when connecting the filter to respective ports of a DC brush drive.

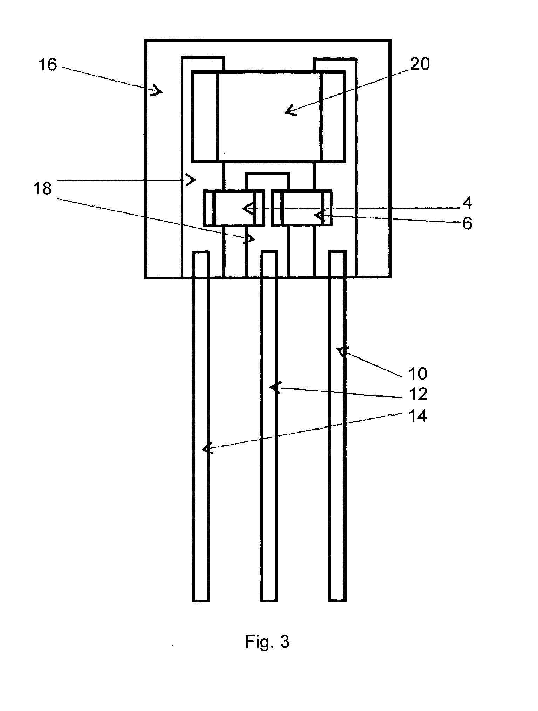

Additional space-saving measures have been achieved by exploiting similarities in the arrangement of electrical contacts of the varistor (8) and the parallel connected capacitor (2). As illustrated in Fig. 3, the varistor (8) and capacitor (2) can be stacked in the two-pole component (20) so that their contacts abut and are electrically connected. By this way, the contacts of the varistor (8) and capacitor (2) are directly connected, without requiring the copper connection paths (18) illustrated in Fig. 2. In other words, the varistor (8) and capacitor (2) are stacked to form a single two-pole component (20) comprising and connecting the varistor (8) and capacitor (2). It follows that the number of connections (18) is reduced, which further reduces the space required for the filter.

As mentioned above, reducing the overall size of the filter allows a more compact installation, which is particularly useful when the filter is required to fit into a compact housing of for example a DC brush drive.

Another aspect of improving electromagnetic interference filters relates to enhancing the rejection of broadband electromagnetic interferences (EMI). For this purpose, filter characteristics may be improved by adding filter stages to the filter circuit. Moreover, encapsulating the filter in a conductive metal casing is known to further suppress the broadband electromagnetic interferences (EMI). However, although such measures improve the broadband electromagnetic interference rejection characteristics, they unfortunately also increase of the overall size of the filter.

Consequently, the conventional design of filters for suppressing broadband electromagnetic interferences (EMI) has been guided by aspects of providing a filter having compact dimensions and sufficient broadband electromagnetic interference rejection capabilities.

### SUMMARY OF THE INVENTION

Accordingly, a problem underlying the invention is to provide filtering devices and methods of manufacturing such devices such that the filtering devices suppress broadband electromagnetic interferences (EMI) with improved broadband electromagnetic interference rejection capabilities.

This problem is solved by an electronic component for filtering voltage disturbances as defined in claim 1, an electrical motor, electrical machine and brush-commutator comprising the electronic component as defined in claims 11 and 14, as well as by a method of manufacturing the electronic component according to claim 15. Preferable embodiments are defined in the dependent claims.

The electronic component for filtering voltage disturbances according to the present invention comprises
- a plurality of stacked electronic elements having conductive areas on their outer surface,
- wherein the conductive areas of adjacently stacked electronic elements are electrically connected, and
- wherein at least one of the electronic elements comprises at least two capacitors.

Hence, the present invention provides an electronic component for filtering voltage disturbances comprising a plurality of stacked electronic elements. In the present disclosure, the term "electronic element" shall have a broad meaning and generally refer to an element comprising an electronic component, such as for example a varistor, capacitor, inductor, resistor or semiconductor. The electronic element may also comprise a plurality of electronic components, such as for example a plurality of capacitors. Further, the electronic element may comprise circuits, such a filter circuits which may be active or passive.

Each of the stacked electronic elements is adapted to have conductive areas on their outer surface. The conductive areas are at least partly electrically connected to the electrical components comprised by the electronic element. Thus, by arranging the conductive areas at the outer surface of the electronic elements, the conductive areas provide contacts to electronic components which are accessible from the outside of the electronic elements. The conductive areas may have any size and shape. For example, the conductive areas may represent flat, convex or concave surfaces. It is also possible to have conductive areas cover an edge, a corner or a side of the electronic element. This allows accessing the conductive areas from different sides of the electronic element.

The material of the conductive areas can belong to any type of electrically conductive substances, such as for example copper, gold, aluminum, silver and graphite.

The surface of the electronic elements which is not covered by a conductive area may be made of an electrically isolating material.

According to the present invention a plurality of electronic elements having conductive areas on their outer surface are stacked. In the present disclosure, the term "stacked electronic elements" refers to the arrangement of a plurality of electronic elements wherein each of the electronic elements is physically connected with at least one of the remaining electronic elements. For example, the electronic elements may be stacked to form a brick-wall resembling structure. Alternatively, the electronic elements may be stacked to form a row having a column-like structure. The respective physical connection of the stacked elements may be direct physical contact or an intermediate contact via an adhesive layer or via any other type of layer constituting fastening means and adapted to physically connect the stacked elements.

As mentioned above, each of the electronic elements is physically connected with at least one of the remaining electronic elements. In this respect, any pair of electronic elements which are physically connected are termed "adjacently stacked electronic elements". For example, the first and second elements in a row of electronic elements are physically connected and represent "adjacently stacked electronic elements".

According to the present invention, each of the stacked electronic elements has conductive areas on their outer surface, and the conductive areas of adjacently stacked electronic elements are electrically connected. By electrically connecting the conductive areas of adjacently stacked electronic elements, the electrical components comprised by the stacked electronic elements are electrically connected to form at least a part of a filter circuit.

According to the present invention, at least one of the electronic elements comprises at least two capacitors. Thus, at least one of the stacked elements comprises two capacitors and is electrically connected to adjacently stacked electronic elements. It follows that the two capacitors are integrated into a single electronic element and this single electronic element is electrically connected to adjacently stacked electronic elements comprising additional electronic components. By having the two capacitors comprised by a single electronic element, the arrangement of the two capacitors can be electrically connected to other electronic components via the conductive areas using very compact and short connection paths.

By shortening the connection paths in accordance with the present invention, the connection paths become less suited to emit electromagnetic interferences. Consequently, the broadband electromagnetic interference rejection capability of the filter is improved. Moreover, since the two capacitors are comprised in a single electronic element, they can be compactly arranged and connected with short connection paths, which further improves the broadband electromagnetic interference rejection capabilities of the filter. As a matter of fact, spectral analysis based laboratory measurements have shown that stacking the at least two capacitors in a single electronic element in accordance with the present invention, is particularly effective to improve the broadband electromagnetic interference rejection capabilities of the filter.

More specifically, laboratory measurements according to the standards of the CISPR (Comité international special des perturbations radioelectriques) have been performed on an LF Recliner DC motor by applying the conventional filter illustrated in Fig. 2. The conventional filter includes a varistor and three capacitors (470nF, 10nF, 10nF) as discrete (non-stacked) components. The laboratory measurements show that by applying the conventional filter, the radiated emission of electromagnetic interferences of the DC motor having no filter is reduced by 7,5dB in the low frequency range 100kHz - 30MHz and by 0,3dB in the high frequency range 30MHz - 1GHz. Moreover, the conducted emission is reduced by 19,5dB.

The same laboratory setup was used to measure the reduction of electromagnetic interferences when applying the filter according to the present invention. For this purpose, the two capacitors having 10nF are now included in a single stacked electronic element of the filter. The corresponding laboratory measurements show that by applying the filter according to the present invention, the radiated emission of electromagnetic interferences of the DC motor having no filter is reduced by 8,5dB in the low frequency range 100kHz - 30MHz and by 4 dB in the high frequency range 30MHz - 1GHz. Moreover, the conducted emission is reduced by 19,6dB.

Table 1 below summarizes the laboratory measurement results.

**Table 1: Reduction of electromagnetic interference in an LF Recliner DC motor**

| | Conventional filter: discrete (non-stacked) filter elements | Filter of the invention: stacked element with two capacitors |
|---|---|---|
| Radiated emission (100kHz - 30MHz) | 7,5dB | 8,5dB |
| Radiated emission (30MHz-IGHz) | 0,3dB | 4,0dB |
| Conducted emission | 19,5dB | 19,6dB |

The results show that the filter according to the present invention improves the electromagnetic interference rejection capabilities, regardless of whether radiated or conductive emissions are involved. The most significant improvement becomes evident when the source of electromagnetic interferences has high frequency (30MHz-1GHz) radiated emission components. In other words, stacking an electronic element including two capacitors according to the present invention allows reducing the lengths of connection paths of the filter to such a degree that the short wavelengths of the high frequency radiated emission are significantly affected.

Preferably, the conductive areas of adjacently stacked electronic elements are arranged close to each other in order to provide short connection paths. For example, the conductive areas of adjacently stacked electronic elements can be arranged in direct physical contact, soldered together or adhered together by a conductive adhesive. Also for the purpose of having the conductive areas of adjacently stacked electronic elements arranged close to each other, the conductive areas of adjacently stacked electronic elements may be formed to abut or engage with each other.

It is also preferred to have at least one of the electronic elements comprise a varistor. The varistor can be used to provide additional overvoltage protection which may for example be useful for DC brush drives. The electronic element comprising the varistor can be adjacently stacked and electrically connected to an electronic element comprising at least one capacitor.

It is advantageous to have the electronic component comprise at least one electronic element having two or three capacitors. By increasing the number of electronic components in an electronic element, the electronic components can be arranged compactly and efficiently. Moreover, such compact arrangement of electronic components allows further shortening of the connection paths and reduced dimensions of the circuit. Consequently, the broadband electromagnetic interference rejection capabilities of the filter are enhanced.

In a preferred embodiment, at least one of the electronic elements comprises a multiple layer chip, a multiple layer varistor chip or a multiple layer ceramic chip having at least one capacitor. Multiple layer electronic components have a compact structure which is well suited for forming broadband electromagnetic interference rejection filters. Further, multiple layer structures may be used to provide a plurality of electronic components, in a compact arrangement with short connection paths, which further enhances the broadband electromagnetic interference rejection capabilities of the filter.

Preferably, the electronic component comprises a plurality of connectors for connecting the component to external devices, such as for example to the ports of an electrical motor or machine. The connectors are preferably electrically connected to conductive areas on the outer surfaces of the stacked electronic elements. It is further preferred that the connectors are arranged to be in direct physical contact to, soldered to or adhered to the conductive areas of the stacked electronic elements. By this way, the connectors can be adapted to extend along the surface of and physically support the stacked electronic elements.

Such connectors may be adapted to extend away from the stacked electronic elements in order to simplify the handling of the electronic component. For example, the connectors may be configured to have the electronic component provide a through-hole component for a printed circuit board. In the present disclosure, the term "through-hole components" relates to components adapted to be mounted into holes of a printed circuit board. For example, the connectors of the electronic component may be feed into holes of a printed circuit board and fastened by soldering for improved fastening and protection against mechanical stresses, such as for example vibrations.

Alternatively, the electronic component may be adapted to provide a surface-mounted device (SMD) rather than using through-holes for mounting the device on a printed circuit board. For this purpose, applying the stacking of electronic elements in accordance with the present invention provides a useful approach to reduce the size and dimensions of the filter and thereby achieve appropriate fitting on the printed circuit board surface.

In a preferred embodiment, the electronic component is provided with an outer coating, such as an epoxy coating, encapsulating the stacked electronic elements. By this way, the coating provides protection for the electronic component, for example against mechanical stresses, vibrations, high temperatures and humidity. The material of the coating can be selected to enhance by electrical isolation the broadband electromagnetic interference rejection capabilities of the filter. For example, the coating may be made of a plastic material.

The electrical motor or electrical machine according to the present invention comprises
- a brush-commutator arrangement and
- an electronic component according to one of the aforementioned embodiments (the present invention),
- wherein the electronic component is adapted to filter voltage disturbances generated by the brush-commutator arrangement.

As mentioned above, a brush-commutator in an electrical motor or machine acts as a switch to switch off/on electrical currents of the motor or machine's windings. The windings of an electrical motor comprise inductive load. By switching the electrical current of the inductive load on/off, voltage surges or peaks are induced by the inductive load. Consequently, broadband electromagnetic interferences (EMI) are generated in the frequency domain, which add to noise and disturbance levels and degrade the performance of electronic devices susceptible to picking up such electromagnetic interferences.

In order to effectively suppress electromagnetic interferences, the present invention suggests to have the electrical motor or machine comprise the electronic component according to the present invention, and to have the electronic component adapted to filter voltage disturbances generated by the brush-commutator arrangement. By having the electronic component comprised by the electrical motor or machine, the filter is arranged in close vicinity to the source generating electromagnetic interferences. Suppressing the voltage disturbances at their source further improves the broadband electromagnetic interference rejection capabilities of the filter. Moreover, by having the electrical motor or machine comprise the electronic component according to the present invention, the electrical motor or machine represents a single compact unit which is protected against the emission of broadband electromagnetic interference. This holds in particular if the electronic component is encapsulated into the electrical motor or electrical machine, such as into a brush holder component of the brush-commutator arrangement.

Preferably, the electronic component comprises three connectors which are electrically connected to power supply terminals and the outer body of the electrical motor or machine. This arrangement protects the environment of the electrical motor or machine against broadband electromagnetic interferences generated by the electrical motor or machine. This type of protection is particularly useful if the electronic component is used to shield devices which are galvanically connected to the electrical motor or machine.

As the brush-commutator arrangements acts as a significant source of electromagnetic interferences, the present invention further relates to a brush-commutator component of an electrical motor or machine comprising an integrated electronic component according to the present invention. By having the electronic component comprised by the brush-commutator, it follows that the filter rejecting broadband electromagnetic interferences is arranged in close vicinity to the source of voltage disturbances, which further improves the broadband electromagnetic interference rejection capabilities of the filter. Moreover, by having the brush-commutator comprise the electronic component according to the present invention, the brush-commutator represents a single compact unit which is protected against the emission of broadband electromagnetic interference. This holds in particular since the electronic component is integrated into the brush-commutator.

A method of manufacturing the electronic component according to the present invention comprises the steps of
- providing a plurality of electronic elements having conductive areas on their outer surface, wherein at least one of the electronic elements comprises at least two capacitors;
- stacking the electronic elements by imposing one electronic element after another; and
- electrically connecting the conductive areas of adjacently stacked electronic elements.

Thus, the respective plurality of electronic elements is stacked by imposing one electronic element after another. In other words, the electronic elements are provided and successively arranged by stacking so that each of the electronic elements is physically connected with at least one of the remaining electronic elements. As mentioned above, any stacked pair of electronic elements which are physically connected are termed "adjacently stacked electronic elements". Further, the conductive areas of adjacently stacked electronic elements are electrically connected in order to arrive at the above discussed advantages and benefits of the electronic component for filtering voltage disturbances according to the present invention.

In a preferred embodiment, the method of manufacturing the electronic component comprises the step of integrating the electronic component into an electrical motor or machine, or into a brush-commutator component of an electrical motor or machine. By having the electronic component integrated into the electrical motor or machine, or into a brush-commutator component of an electrical motor or machine, it follows that the respective filter provided by the electronic component is arranged in close vicinity to the source of voltage disturbances. Consequently, the broadband electromagnetic interference rejection capabilities of the filter are improved.

Moreover, by integrating the electronic component into the electrical motor or machine or into the respective brush-commutator component, a single compact unit is provided which is protected against broadband electromagnetic interference. In this respect, the electrical motor or machine or brush-commutator resulting from the above manufacturing process, requires no further upgrading manufacturing step to gain from the benefits of filtering voltage disturbances in accordance with the present invention. The electronic component for filtering voltage disturbances in accordance with the present invention is already integrated into the compact device.

### SHORT DESCRIPTION OF THE FIGURES

- Fig. 1: is a circuit diagram of an electronic filter for limiting voltage disturbances of DC brush drives,
- Fig. 2: is a schematic illustration of an electronic filter comprising four separately connected electronic components,
- Fig. 3: is a schematic illustration of an electronic filter comprising a stacked electronic element including a varistor and capacitor,
- Fig. 4: is a schematic illustration of the manufacturing process of an electronic component for filtering voltage disturbances according to the present invention comprising stacked electronic elements, wherein one of the elements comprises two capacitors,
- Fig. 5: is a schematic illustration of an electronic element comprising a multiple layer chip having two capacitors
- Fig. 6: is a schematic illustration of the manufacturing process of an electronic component for filtering voltage disturbances according to the present invention comprising stacked electronic elements, wherein one of the elements comprises three capacitors,
- Fig. 7: is a schematic illustration of an electronic element comprising a multiple layer chip having three capacitors

### DESCRIPTION OF THE PREFERRED EMBODIMENTS

For the purposes of promoting an understanding of the principles of the invention, reference will now be made to the preferred embodiments illustrated in the drawings and specific language will be used to describe the same. It will nevertheless be understood that no limitation of the scope of the invention is thereby intended, such alterations and further modifications in the illustrated devices and method and such further applications of the principles of the invention as illustrated therein being contemplated therein as would normally occur now or in the future to one skilled in the art to which the invention relates.

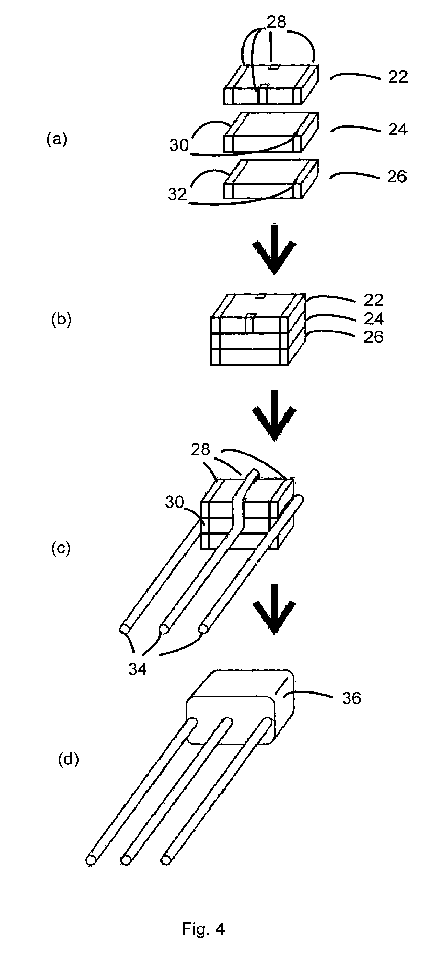

Fig. 4 is a schematic illustration of the manufacturing process of an electronic component according to the present invention. The manufacturing process comprises the steps of
(a) providing three electrical elements having conductive areas on their outer surfaces
(b) stacking the electronic elements by imposing one electronic element after another and electrically connecting the conductive areas of adjacently stacked electronic elements
(c) soldering connectors to conductive areas of the stacked electronic elements
(d) encapsulating the electronic component with an epoxy coating.

In step (a), three electronic elements (22, 24, 26) having conductive areas (28, 30, 32) on their outer surfaces are provided. The first electronic element (22) comprises two capacitors, the second electronic element (24) comprises a varistor and the third electronic element (26) comprises a capacitor. The ports of the capacitors and varistor are electrically connected to conductive areas (28, 30, 32) on the outer surfaces of the respective electronic elements (22, 24, 26). The conductive areas (28, 30, 32) are arranged at the sides of the electronic element (22, 24, 26). By this way, the conductive areas (28, 30, 32) can be accessed from a plurality of directions. For example, the conductive areas (32) of the bottommost electronic element (26) can be accessed from the top, bottom and sides of the electronic component. The conductive areas are made of an electrically conductive material, such as for example copper, gold, silver or aluminum.

In step (b), the plurality of electronic elements (22, 24, 26) are stacked so that each of the electronic elements is physically connected with at least one of the remaining electronic elements. For example, the bottommost electronic element (26) is in physical contact with the middle electronic element (24). The electronic elements are stacked to form a row having a column-like structure and the physical connection between the stacked elements is provided by soldering together the conductive areas (28, 30, 32) of adjacently stacked electronic elements. For example, the conductive areas (30, 32) of the adjacently stacked middle and bottommost electronic elements (24, 26) are soldered together in order to physically contact the adjacently stacked electronic elements (24, 26) and also to electrically connect the conductive areas (30, 32) of the adjacently stacked electronic elements (24, 26). By electrically connecting the conductive areas (28, 30, 32) of adjacently stacked electronic elements (22, 24, 26), the electrical components (varistor and capacitors) comprised by the stacked electronic elements are electrically connected to form at least a part of a filter circuit.

In step (c), connectors (34) are soldered to conductive areas (28, 30) of the stacked electronic elements. Thus, the connectors (34) are electrically connected to the conductive areas (28, 30) and extend away from the electronic elements for providing connectors which are suitable for connecting the component to external devices, such as for example to the ports of an electrical motor or machine. Moreover, the connectors (34) are adapted to extend along the surface of the electronic elements and thereby physically support the stacked electronic elements against mechanical strain or vibrations.

In step (d), the electronic elements are encapsulated with an epoxy coating (36) for protection against mechanical stresses, vibrations, high temperatures and/or humidity.

In other words, one of the electronic elements (22) comprises two capacitors and is electrically connected to the adjacently stacked electronic element (24) via the conductive areas (28, 30). It follows that the two capacitors are compactly integrated into a single electronic element and this single electronic element is electrically connected to adjacently stacked electronic elements comprising additional electronic components. Thus, the arrangement of two capacitors is connected to other electronic components of the filter circuit using very compact and short connection paths.

As discussed above, the shorter connection paths in accordance with the present invention are less suited to emit electromagnetic interferences. Thus, the broadband electromagnetic interference rejection capability of the filter is improved.

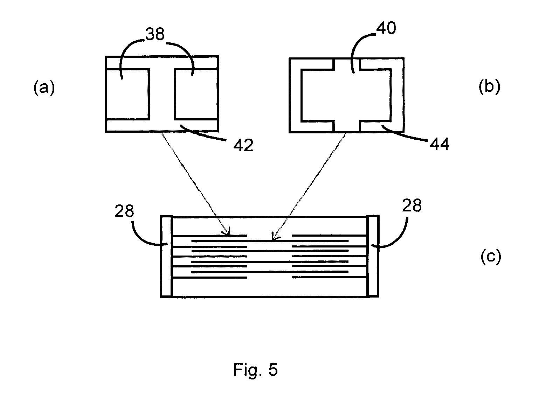

A possible arrangement of two capacitors in a single electronic element (22) is provided by the multiple layer chip illustrated in Fig. 5. In this arrangement, differently shaped electrically conductive layers (38, 40) are separated by electrically isolating layers (42, 44). The top-views shown in Figs. 5(a) and (b) illustrate two different shapes of the electrically conductive layers (38, 40) and the side-view provided in Fig. 5(c) shows how the electrically conductive layers (38, 40) are separated by electrically isolating layers (42, 44). The electrically conductive layers (38, 40) are electrically connected by the conductive areas (28) at the outer surface of the electronic element (22). Thus, by having the two capacitors comprised in a single electronic element (22) a compact arrangement of the capacitors is achieved with short connection paths. As discussed above, shortening the connection paths further enhances the broadband electromagnetic interference rejection capabilities of the filter.

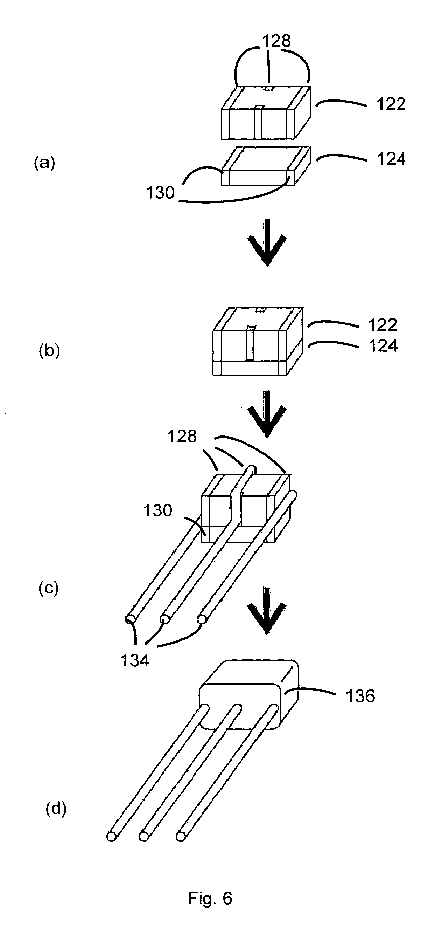

Fig. 6 is a schematic illustration of the second manufacturing process of an electronic component according to the present invention. The manufacturing process comprises the steps of
(a) providing two electrical elements having conductive areas on their outer surfaces
(b) stacking the electronic elements by imposing one electronic element after another and electrically connecting the conductive areas of adjacently stacked electronic elements
(c) soldering connectors to conductive areas of the stacked electronic elements
(d) encapsulating the electronic component with an epoxy coating.
(e)

In step (a), two electronic elements (122, 124) having conductive areas (128, 130) on their outer surfaces are provided. The first electronic element (122) comprises three capacitors and the second electronic element (124) comprises a varistor. The ports of the capacitors and varistor are electrically connected to conductive areas (128, 130) on the outer surfaces of the respective electronic elements (122, 124). The conductive areas (128, 130) are arranged at the sides of the electronic element (122, 124). By this way, the conductive areas (128, 130) can be accessed from a plurality of directions. For example, the conductive areas (130) of the bottom electronic element (124) can be accessed from the top, bottom and sides of the electronic component. The conductive areas are made of an electrically conductive material, such as for example copper, gold, silver or aluminum.

In step (b), the two electronic elements (122, 124) are stacked so that they are in physical contact with each other. The electronic elements are stacked to form a row having a column-like structure and the physical connection between the stacked elements is provided by soldering together the conductive areas (128, 130) of the adjacently stacked electronic elements. Thus, the conductive areas (128, 130) of the adjacently stacked electronic elements (122, 124) are soldered together in order to physically contact the adjacently stacked electronic elements (122, 124) and also to electrically connect their conductive areas (128, 130). By electrically connecting the conductive areas (128, 130) of the two electronic elements (122, 124), the electrical components (varistor and capacitors) comprised by the electronic elements are electrically connected to form at least a part of a filter circuit.

In step (c), connectors (134) are soldered to conductive areas (128, 130) of the stacked electronic elements. Thus, the connectors (134) are electrically connected to the conductive areas (128, 130) and extend away from the electronic elements for providing suitable connectors for connecting the component to external devices, such as for example to the ports of an electrical motor or machine. Moreover, the connectors (134) are adapted to extend along the surface of the electronic elements and thereby physically support the stacked electronic elements against mechanical strain or vibrations.

In step (d), the electronic elements are encapsulated with an epoxy coating (136) for protection against mechanical stresses, vibrations, high temperatures and/or humidity.

In other words, one of the electronic elements (122) comprises three capacitors and is electrically connected to the adjacently stacked electronic element (124) via the conductive areas (128, 130). It follows that the three capacitors are compactly integrated into a single electronic element and this single electronic element is electrically connected to adjacently stacked electronic elements comprising additional electronic components. Thus, the arrangement of three capacitors is connected to other electronic components of the filter circuit using very compact and short connection paths.

As discussed above, the shorter connection paths are less suited to emit electromagnetic interferences. Thus, the broadband electromagnetic interference rejection capability of the filter is improved.

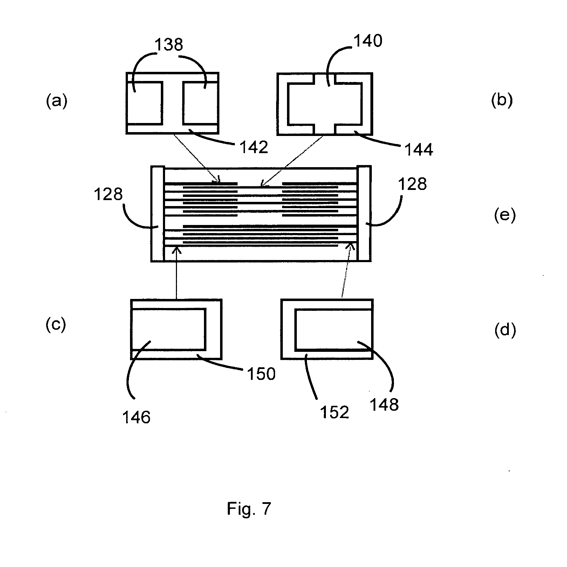

A possible arrangement of three capacitors in a single electronic element (122) is provided by the multiple layer chip illustrated in Fig. 7. In this arrangement, differently shaped electrically conductive layers (138, 140,146, 148) are separated by electrically isolating layers (142, 144, 150, 152). The top-view shown in Figs. 7(a), (b), (c) and (d) illustrate four different shapes of electrically conductive layers (138, 140, 146, 148) and the side-view provided in Fig. 7(e) shows how the electrically conductive layers (138, 140, 146, 148) are separated by electrically isolating layers (142, 144, 150, 152). The electrically conductive layers (138, 140, 146, 148) are electrically connected by the conductive areas (128) at the outer surface of the electronic element (122). Thus, by having the three capacitors comprised in a single electronic element (122) a compact arrangement of the capacitors is achieved with short connection paths. As already discussed, shortening the connection paths enhances the broadband electromagnetic interference rejection capabilities of the filter.

The embodiments described above and the accompanying figures merely serve to illustrate the method and devices according to the present invention, and should not be taken to indicate any limitation thereof. The scope of the patent is solely determined by the following claims.

### LIST OF REFERENCE SIGNS

- 2, 4, 6: capacitors
- 8: varistor
- 10, 12, 14, 34, 134: connectors
- 16: printed circuit board
- 18: connection paths
- 20: two-pole component
- 22, 24, 26, 122, 124: electronic elements
- 28, 30, 32, 128, 130: conductive areas
- 36, 136: epoxy coating
- 38, 40, 138, 140, 146, 148: electrically conductive layers
- 42, 44, 142, 144 150, 152: electrically isolating layers

## Claims

1. An electronic component for filtering voltage disturbances, comprising a plurality of stacked electronic elements having conductive areas on their outer surface,
wherein the conductive areas of adjacently stacked electronic elements are electrically connected, and
wherein at least one of the electronic elements comprises at least two capacitors.

2. The electronic component according to claim 1, wherein the conductive areas of adjacently stacked electronic elements are in direct physical contact, soldered together or adhered together by a conductive adhesive.

3. The electronic component according to claim 1 or 2, wherein at least one of the electronic elements comprises a varistor.

4. The electronic component according to claim 3, wherein the electronic element comprising a varistor and an electronic element comprising at least one capacitor are adjacently stacked and electrically connected.

5. The electronic component according to any of the preceding claims, wherein at least one of the electronic elements comprises two or three capacitors.

6. The electronic component according to any of the preceding claims, wherein at least one of the electronic elements comprises a multiple layer chip, a multiple layer varistor chip or a multiple layer ceramic chip having at least one capacitor.

7. The electronic component according to any of the preceding claims, comprising a plurality of connectors which are electrically connected to conductive areas on the outer surfaces of the stacked electronic elements.

8. The electronic component according to claim 7, wherein the connectors are in direct physical contact to, soldered to or adhered to said conductive areas of the stacked electronic elements.

9. The electronic component according to any of the preceding claims, wherein the connectors are configured so that the electronic component provides a through-hole component for a printed circuit board.

10. The electronic component according to any of the preceding claims, further comprising an outer coating, such as an epoxy coating, encapsulating the stacked electronic elements.

11. An electrical motor or an electrical machine having a brush-commutator arrangement and comprising the electronic component according to any of the preceding claims, wherein the electronic component is adapted to filter voltage disturbances generated by the brush-commutator arrangement.

12. The electrical motor or electrical machine according to claim 11, wherein the electronic component is encapsulated into the electrical motor or electrical machine, such as into a brush holder component of the brush-commutator arrangement.

13. The electrical motor or electrical machine according to claim 11 or 12, wherein the electronic component comprises three connectors which are electrically connected to power supply terminals and the outer body of the electrical motor or machine, respectively.

14. A brush-commutator component of an electrical motor or machine, comprising an integrated electronic component according to any of the claims 1 to 10.

15. A method of manufacturing an electronic component according to any of the claims 1 to 10, comprising the steps of
providing a plurality of electronic elements having conductive areas on their outer surface, wherein at least one of the electronic elements comprises at least two capacitors; stacking the electronic elements by imposing one electronic element after another; and electrically connecting the conductive areas of adjacently stacked electronic elements,
wherein said method preferably further comprises a step of integrating the electronic component into an electrical motor or machine or into a brush-commutator component of an electrical motor or machine.
